Europäisches Patentamt

European Patent Office

Office européen des brevets

(19)

(11) **EP 0 759 481 A1**

(12) **EUROPEAN PATENT APPLICATION**

(43) Date of publication:
26.02.1997 Bulletin 1997/09

(51) Int. Cl.$^6$: **C23C 16/40**, H01L 21/316

(21) Application number: 96201647.3

(22) Date of filing: 13.06.1996

(84) Designated Contracting States:
CH DE FR GB IT LI NL

(30) Priority: 23.06.1995 US 494616

(71) Applicant: **Novellus Systems, Inc.**
San Jose, CA 95134 (US)

(72) Inventors:
• **Carl, Daniel A.**
Mountain View, CA 94040 (US)

• **Schuchmann, Shari**
Sunnyvale, CA 94086 (US)

(74) Representative: **Van kan, Johan Joseph Hubert, Ir. et al**
**Algemeen Octrooibureau**
P.O. Box 645
5600 AP Eindhoven (NL)

(54) **Method of depositing a stable fluorinated TEOS film**

(57) A plasma enhanced chemical vapor deposition parallel plate reactor is provided with a dual frequency RF power source. The low frequency RF power source provides more power than the high frequency power source during deposition of a fluorine-doped silicon dioxide film from TEOS, oxygen, and fluorine. The ratio of oxygen partial pressure to TEOS partial pressure is substantially high. The resulting film is stable and has excellent step coverage and planarity.

EP 0 759 481 A1

## Description

### BACKGROUND OF THE INVENTION

#### Field of the Invention

This invention relates to a method of depositing material using chemical vapor deposition (hereinafter "CVD"), and more particularly to a method of depositing a fluorine-doped silicon dioxide film from tetraethylorthosilicate (hereinafter "TEOS") using plasma enhanced chemical vapor deposition (hereinafter "PECVD").

#### Description of Related Art

As device dimensions continue to decrease, the need for high quality dielectric films that can fill aspect ratios greater than 1:1 becomes more critical. This is particularly true of the 0.35 μm technologies and beyond, which demand stringent intermetal dielectric gap fill and lower dielectric constants.

The term "aspect ratio" means the ratio of the depth of the gap to the width of the gap. A gap 110 having a 2:1 aspect ratio, for example, is shown in Figure 1, contrasted with a gap 120 having a 1:1 aspect ratio and a gap 130 having a 1:2 aspect ratio. Figure 2 shows a gap 200 that is filed with an ideally conformal film 202. The portion of the film 202 filling the gap 200 contains no seams or voids, and the surface of the film 202 is planar. Figure 3 shows another gap 300 that is filled with a non-conformal film 302. In contrast with film 202, the portion of the film 302 filling the gap 300 contains a seam 306 and a void 308, and the surface of the film 302 is depressed over the gap 300 (depressed region 304). The film 302 is illustrative of the type of a silicon dioxide film formed from the CVD or the PECVD of silane $(SiH_4)$, for example.

PECVD TEOS oxide films have long been used in the VLSI industry as the intermetal dielectric film of choice due to superior physical and electrical properties coupled with excellent conformal deposition. Void-free fill using PECVD TEOS has worked well up to and including aspect ratios of 0.8:1 in larger than 0.5 μm process integration schemes. However, above aspect ratios of 0.8:1, conventional PECVD TEOS alone cannot be relied upon to provide a void free fill.

While fluorinated tetraethylorthosilicate, or F-TEOS, films have been recognized for their gap fill abilities and have attained nearly ideal characteristics, including an effective dielectric constant of below 4.0, the stability of these films has not been entirely satisfactory. *See, e.g.*, M.B. Anand *et al.*, "Fully Integrated Back End of the Line Interconnected Process for High Performance ULSIs," 1994 VMIC Conference Proceedings, June 7, 1994, pp. 15-21; K. Shimokawa, "Fluorine Doped SiO2 with Low Dielectric Constant for Multilevel Interconnection," Semicon Japan Technical Session Proceedings, December 1, 1993, pp. 211-216; T. Usami *et al*, "Low Dielectric Constant Interlayer Using Fluorine-Doped Silicon Oxide", Japan. J. Appl Phys., Vol 33, 1994, pp. 408-412, and T. Matsudada et al., "Dual Frequency Plasma CVD Fluorosilicate Glass Deposition for 0.25 μm Interlevel Dielectrics," 1995 DUMIC Conference Proceedings, 1995, pp. 22-28. Good Si-F bond stability is necessary if an F-TEOS film is to be successfully integrated into a the structure of a device such as, for example, a semiconductor device for electronic integrated circuits, since free fluorine in the film reacts with water or other materials in the device to pose potential reliability concerns. Moreover, water absorption must be minimized, least the dielectric constant reduction otherwise achieved by incorporation of fluorine into the $SiO_2$ film be counteracted by the polarizability of water and Si-OH in the film. Polarization of water and Si-OH in the film can lead to effective dielectric constants greater than 4.0 even when fluorine is incorporated into the film.

Accordingly, what is desired is a production-viable intermetal dielectric F-TEOS film that has an equivalent or superior stability to currently available gap fill films so that it can be used without requiring barrier or cap films.

### SUMMARY OF THE INVENTION

Advantageously, the present invention provides a stable fluorine-doped silicon dioxide film having excellent step coverage and planarity.

In many embodiments, the present invention extends gap fill capability to an aspect ratio in excess of 1.5:1, provides a lower dielectric constant oxide, stabilizes the fluorine in the film, produces a film having minimal stress hysteresis, achieves excellent particle and process reproducibility, simplifies process integration, and extends to processes at or under 0.5 μm.

In one embodiment, the present invention is a method of depositing a fluorine-doped silicon dioxide film. A substrate is maintained in a plasma-enhanced chemical vapor deposition reactor. A gas mixture comprising a TEOS component, an oxygen component, and a fluorine component is introduced into the reactor, wherein the ratio of the oxygen partial pressure to the TEOS partial pressure is high. Alternating current energy is applied to the gas mixture to excite the gas mixture into a plasma proximate the substrate.

In another embodiment, a method of process integration comprises the steps of the aforementioned method and excludes depositing an encapsulation layer associated with the film.

### BRIEF DESCRIPTION OF THE DRAWINGS

In the drawings, in which like reference characters refer to like parts,

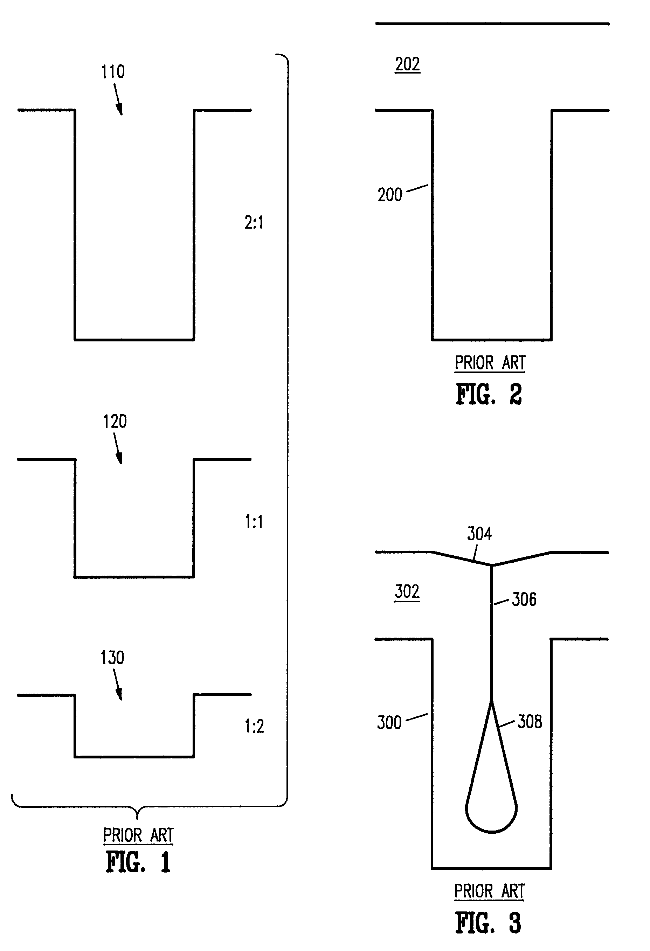

Figure 1 shows cross-sectional views of gaps having various aspect ratios;

Figure 2 is a cross-sectional view of a gap filed with an ideally conformal film;

Figure 3 is a cross-sectional view of a gap filed with a non-conformal film;

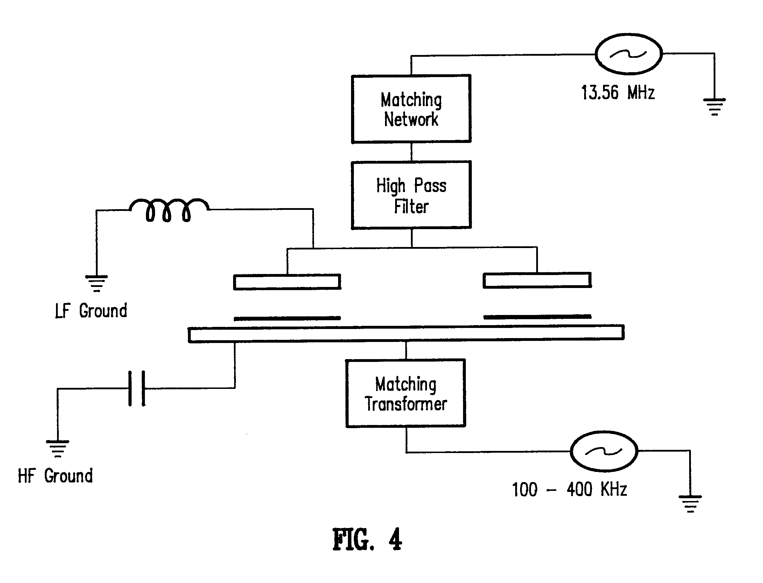

Figure 4 is a schematic diagram of an illustrative radio frequency system useful for depositing films in accordance with the present invention;

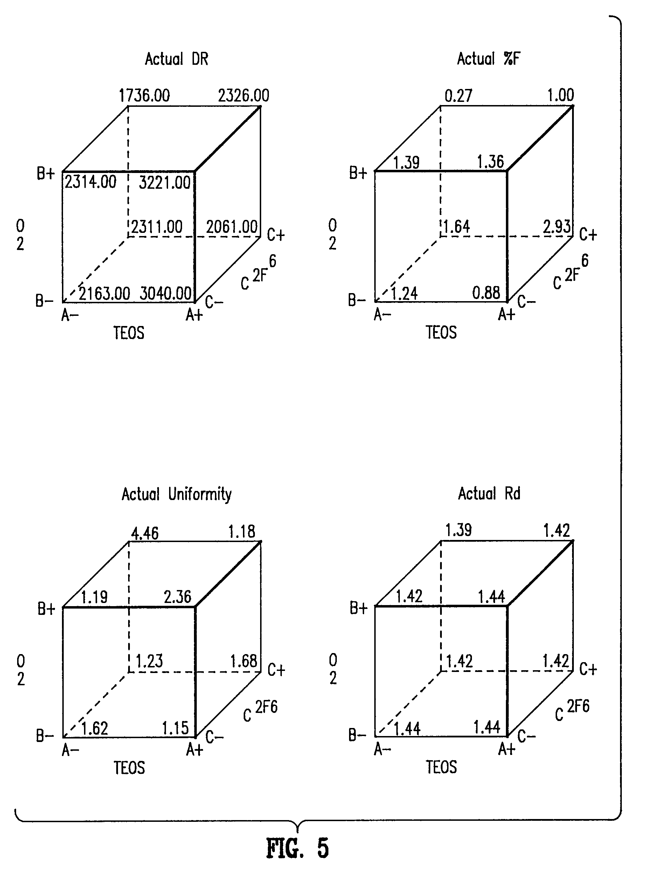

Figure 5 is a schematic diagram of response cubes for the parameters varied in the process factorial of a low power study;

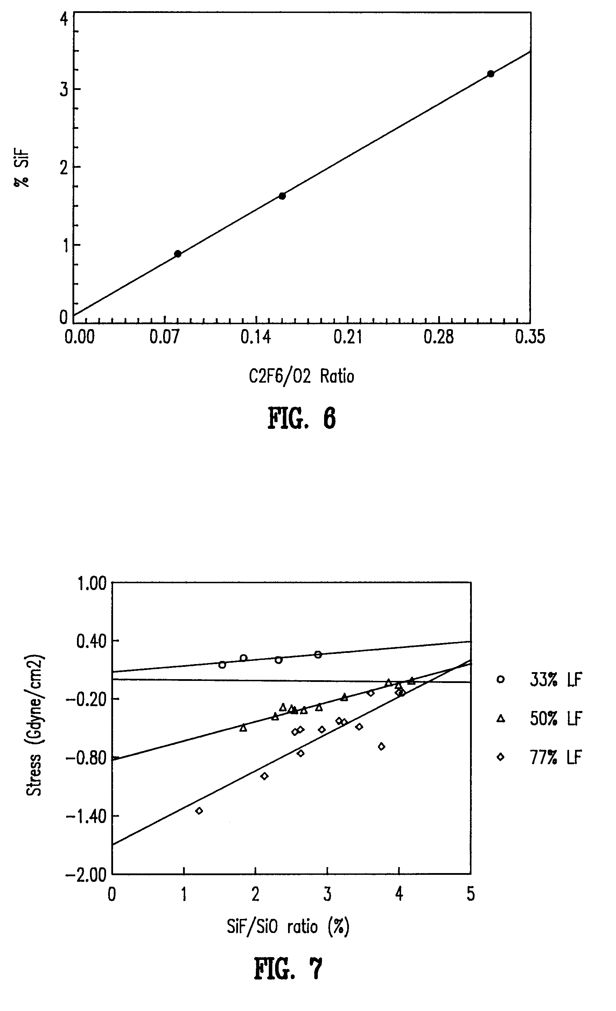

Figure 6 is a plot of the Si-F/Si-O bond ratio versus $O_2:C_2F_6$ ratio at a constant low frequency power, high frequency power, and reactor pressure, as found in the low power study;

Figure 7 is a plot of stress versus Si-F/Si-O bond ratio as a function of the percentage of low frequency power, as found in the low power study;

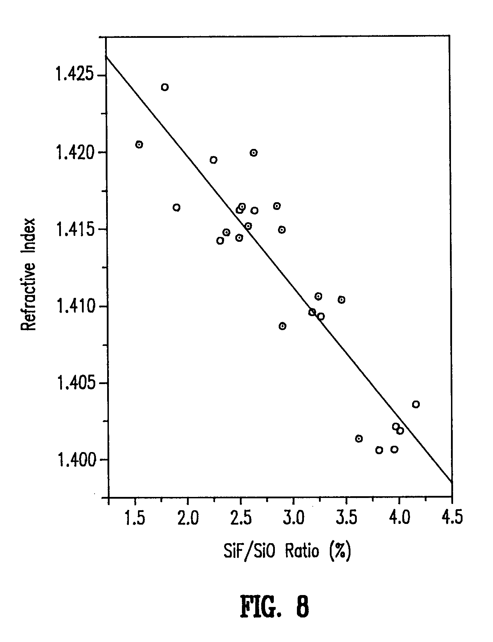

Figure 8 is a plot of all refractive index data points in the factorial analysis versus the Si-F/Si-O bond ratio, as found in the low power study;

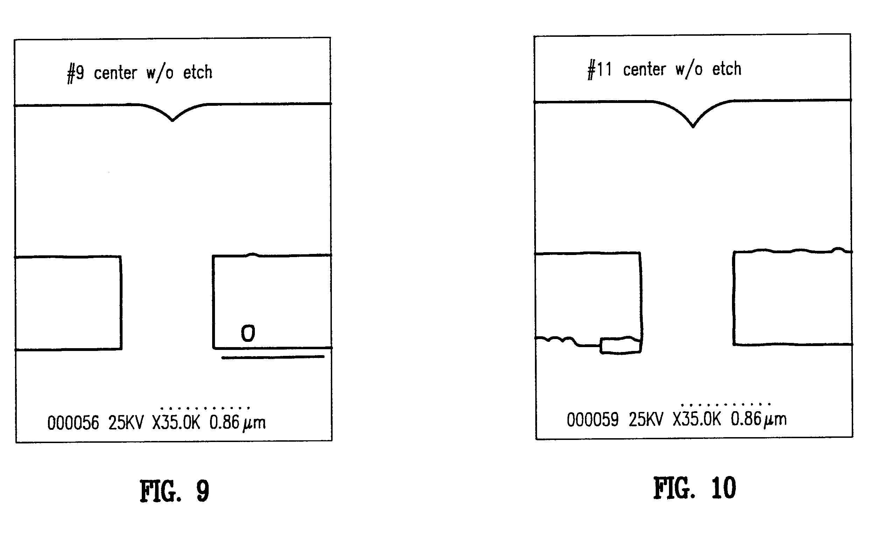

Figure 9 is a representative gap fill of an aspect ratio line/space of about 1.4:1 and a Si-F/Si-O ratio of about 2.5%, as found in the low power study;.

Figure 10 is a representative gap fill of an aspect ratio line/space of about 1.4:1 and a Si-F/Si-O ratio of about 3%, as found in the low power study;

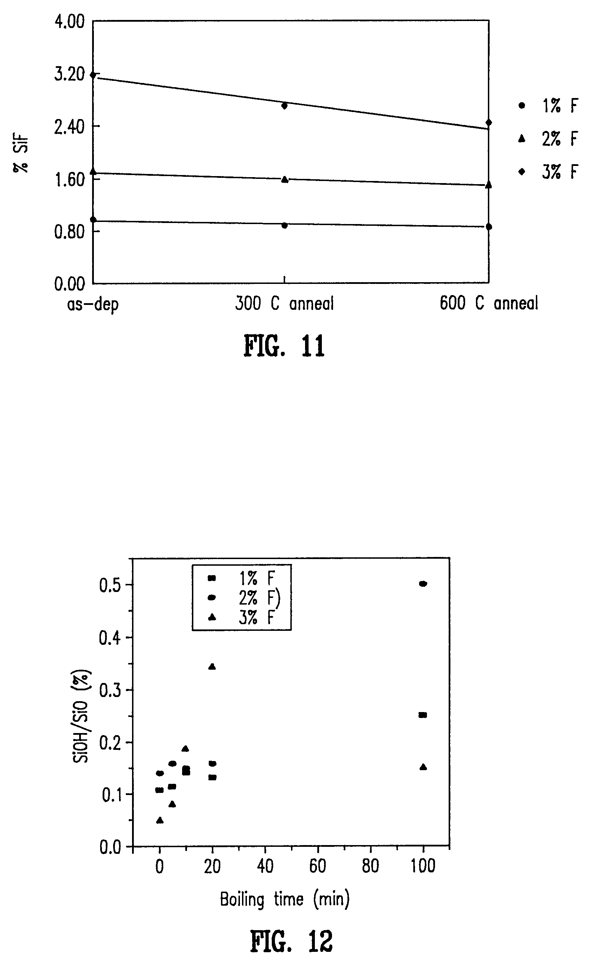

Figure 11 is a plot of the Si-F/Si-O bond areas for one percent, two percent, and three percent fluorine after a 90 minute, 500° C anneal in $N_2$, as found in the low power study;

Figure 12 is a plot of the initial Si-OH/Si-F bond ratio versus time in a 100° C boiling water bath, as found in the low power study;

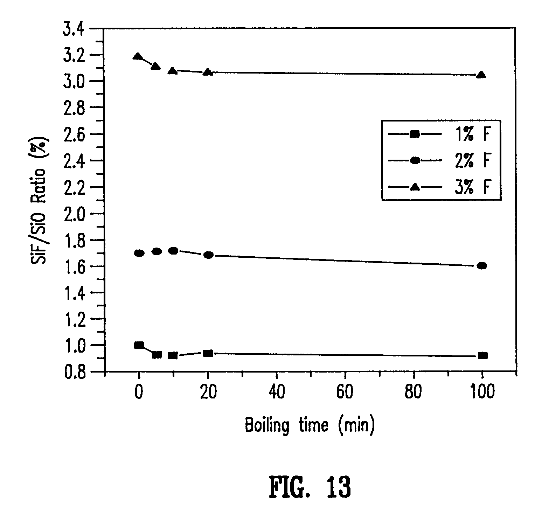

Figure 13 is a plot of the Si-F/Si-O bond ratio versus boiling time for three different Si-F/Si-O initial conditions, as found in the low power study;

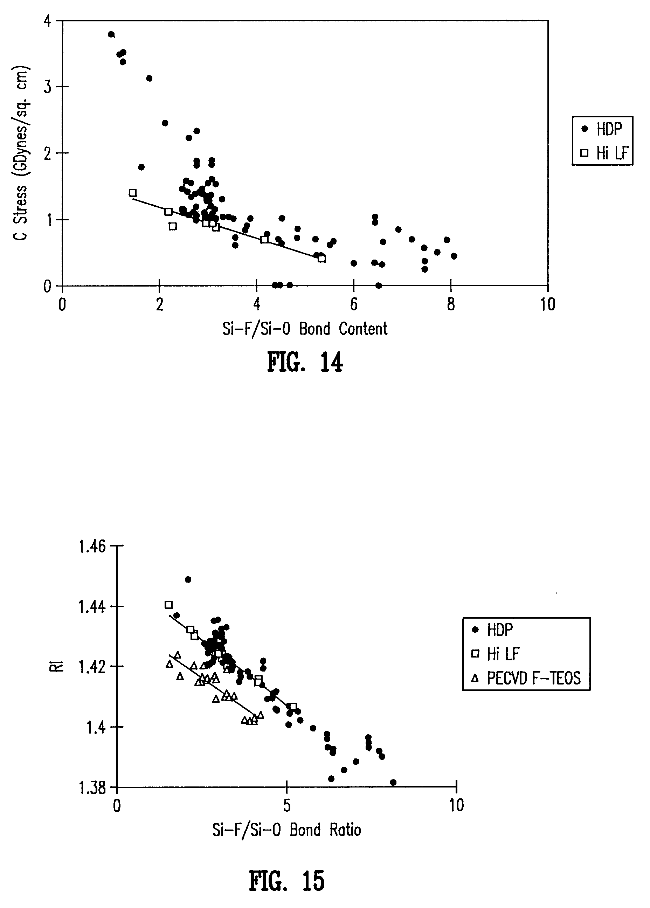

Figure 14 is a plot of refractive index versus Si-F content for standard PECVD F-TEOS films, high low frequency power F-TEOS films, and HDP films, as found in a high low power study;

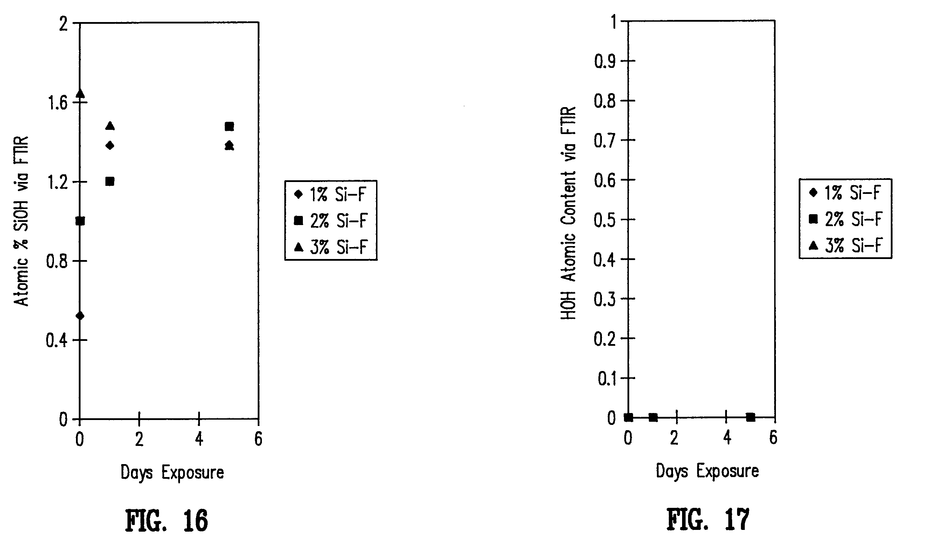

Figure 15 is a plot of stress versus Si-F content for all process conditions in the high low frequency power mode and the HDP mode, as found in the high low power study;

Figure 16 is a plot of SiOH atomic percent for three Si-F content high low frequency power cases versus time in a 100% RH, 65 degree Centigrade oven, as found in the high low power study;

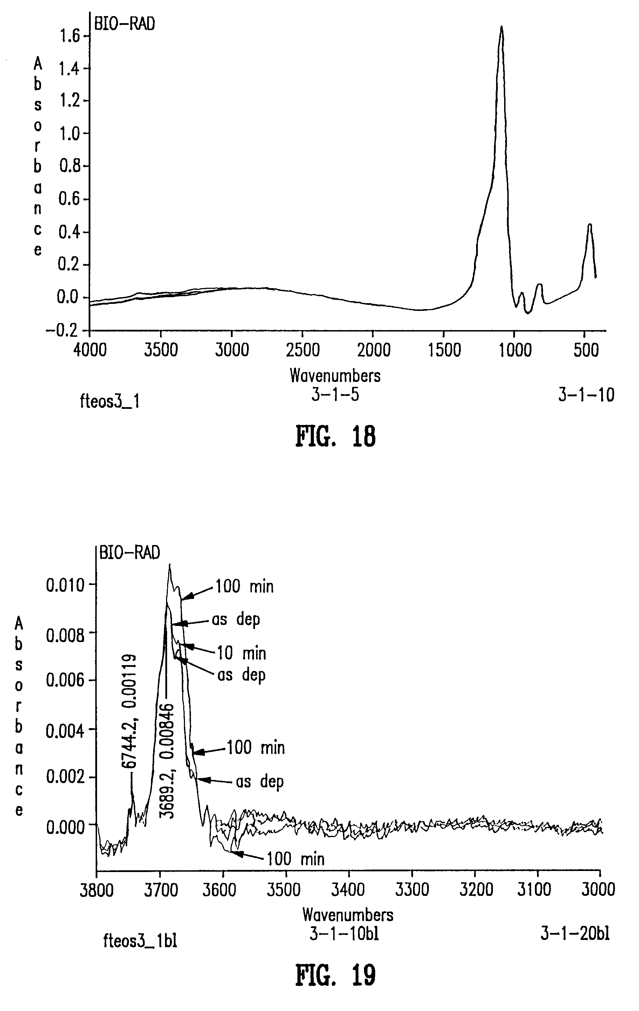

Figure 17 is a plot of HOH atomic percent for three Si-F content cases versus time in a 100% RH, 65 degree Centigrade oven, as found in the high low power study;

Figure 18 and Figure 19 are expansions of the portion of the FTIR spectrum where SiOH and HOH absorbencies were observed for a 2.5% Si-F content Hi LF F-TEOS film after boiling in water for 100 minutes, as found in the high low power study;

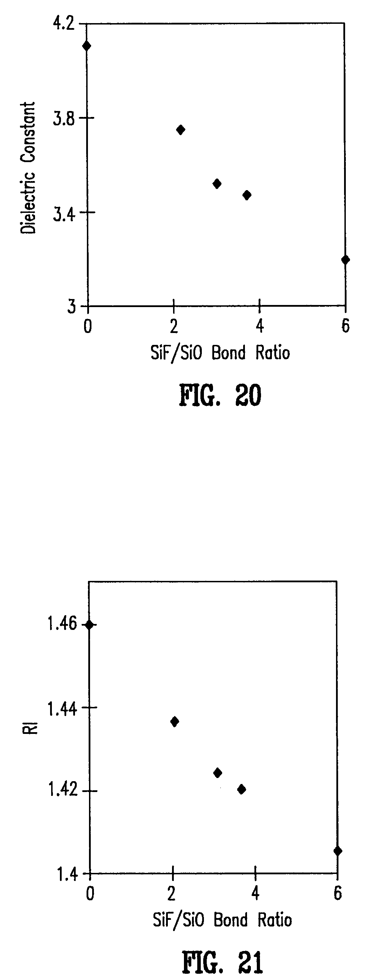

Figure 20 is a plot of dielectric constant versus Si-F/Si-O bond ratios for several illustrative cases; and

Figure 21 is a plot of refractive index versus Si-F/Si-O bond ratios for several illustrative cases.

DESCRIPTION OF THE PREFERRED EMBODIMENT

We have found that key factors to controlling the film stability in a F-TEOS PECVD process is the energy flux of the ion bombardment divided by the deposition rate, high $O_2$:TEOS mole ratios and low PECVD pressures. The energy flux is controllable by using a high amount of total power, a high percentage of low frequency power and, high $O_2$:TEOS mole ratios, and low PECVD pressures. Instead of using dual frequency, a high amount of single frequency power at an optimal frequency may be used. However, as the optimal single frequency for presently known PECVD reactor configurations would be other than the 13.56 MHz presently licensed by the Federal Communications Commission for PECVD operations, the single frequency embodiment is not presently a commercially viable alternative.

Suitable reactors for practicing the F-TEOS PECVD process include the Concept One™ system and the Concept Two™ Sequel™ system available from Novellus Systems, Inc. of San Jose, California. The Novellus Systems reactors are conventional dual frequency multi-station sequential PECVD reactors, although the F-TEOS PECVD process is also suitable for single station reactors such as the Precision 5000™ system available from Applied Materials, Inc. of Santa Clara, California. For practicing the F-TEOS PECVD process, such conventional reactors are modified to operate at higher total power levels (high frequency power plus low frequency power) and with a higher percent of low frequency power. The flux is controlled through the percentage of low frequency power in the discharge and the pressure of operation.

*Low Power Study*

In one study, a dual frequency multi-station sequential deposition PECVD processing system was used to fabricate F-TEOS silicon dioxide films. Mixtures of

TEOS, $O_2$ and $C_2F_6$ were used to deposit F-TEOS films of varying Si-F/Si-O bond ratios, gap filling capabilities, and moisture stabilities. The use of dual frequency PECVD, modulation of the percentage of low frequency power, and optimization of the $O_2$:$C_2F_6$ ratio were investigated to deposited films that filled aspect ratios greater than 1:1 and that simultaneously exhibited little or no difference in the Si-F/Si-O bond peak areas after 500° C anneals or after boiling in water for extended periods. The Si-F content was found to be a function of the $O_2$:$C_2F_6$ ratio in the gas phase and of the system pressure. The refractive index was found to be a linear function of the Si-F/Si-O bond ratio. The deposited stress was found to be a function of the percentage of low frequency power and of the as-deposited Si-F/Si-O bond ratio. Gap fill was seen to depend in a complicated manner on percentage of low frequency power, pressure, and gas phase reactant concentrations. Gap fill of a 1.4:1 aspect ratio space was achieved with no visible seams or voids present.

A Concept One model 200 system was used to deposit the F-TEOS films generated in this study. Figure 4 shows the RF schematic for this system. Details of the process system and configuration are described in B. van Schravendijk et al., "Correlation Between Dielectric Reliability and Compositional Characteristics of PECVD Oxide Films," VMIC Proceedings, June 9-10, 1992, which is incorporated herein by reference in its entirety.

The films were deposited upon 200 mm wafers. Each set of process conditions was represented by at least two trials. Thickness was measured using a model SM200 thin film thickness reflectometer, available from the Prometrix Division of Tencor Corporation of Santa Clara, California. Two hundred twenty five points were used per each 200 mm wafer. The refractive index was measured using a prism coupler available from Metricon Corporation of Pennington, New Jersey. Stress was measured using an FSM 8800 stress measurement gage available from Scientific Measurement Systems of San Jose, California. Quantification of the fluorine content was made with a FTIR available from Biorad Laboratories-DigiLab Division of Cambridge, Massachusetts. The 937 cm$^{-1}$ Si-F peak as a ratio of the 1070 cm$^{-1}$ Si-O peak was used after baseline correction for determining the %F in the film.

Full factorial process characterization was performed to investigate a suitable process window for F-TEOS film formation. Figure 5 is a schematic diagram of response cubes for the parameters varied in the process factorial. The strongest correlations in this study were the relationship between $O_2$:$C_2F_6$ ratio and Si-F/Si-O bond ratio. Figure 6 is a plot of the Si-F/Si-O bond ratio versus $O_2$:$C_2F_6$ ratio at a constant low frequency power, high frequency power, and reactor pressure. As is apparent from Figure 6, the Si-F/Si-O bond ratio increased with a decrease in the $O_2$:$C_2F_6$ ratio. This phenomena is explained by considering the following two possible surface chemical reactions.

$$Si_{[surface]} + O_{[adsorbed]} \rightarrow Si\text{-}O \qquad (1)$$

$$Si_{[surface]} + F_{[adsorbed]} \rightarrow Si\text{-}F \qquad (2)$$

Adsorbed reactant concentration is generally considered to be proportional to the gas phase concentration of the reactant. The greater the amount of fluorine radicals generated in the plasma phase and the lower the amount of oxygen radicals, the greater the formation rate of Si-F (Equation 2) and the lesser the formation rate of Si-O (Equation 1).

Incorporation of Si-F bonding changes the physical properties of the material, shifting the 1070 cm$^{-1}$ Si-O stretch to higher wavenumbers (up to 1095 cm$^{-1}$) as well as modulating the as-deposited stress of the F-TEOS film. This is seen in Figure 7, which is a plot of stress versus Si-F/Si-O bond ratio as a function of the percentage of low frequency power. In the case of conventional TEOS PECVD deposition, a unique TEOS stress state exists for a given percentage of low frequency power of the total power setting. In the F-TEOS case, two factors are involved; viz. the Si-F/Si-O ratio and the percentage of low frequency power. For the same Si-F/Si-O bond density, increasing the percentage of low frequency power does indeed increase the film stress. The data in Figure 7 also show that if the percentage of low frequency power is held constant, the addition of more Si-F bonding character significantly lowers the film stress towards a more tensile condition. This may be due to an opening up of the bonding structure or a change in the ring-like nature of the amorphous glass material. This "opening" of the bonding structure is partially compensated for by increasing the percentage of low frequency power (and therefore increasing the ion bombardment flux), which results in a denser and more compressive film. Figure 7 also shows a convergence to net zero stress for high Si-F content. This may indicate that high Si-F content films (4% Si-F/Si-O bond ratio) will tend towards an equilibrium stress value, regardless of the percentage of low frequency power applied.

Figure 8 is a plot of all refractive index data points in the factorial analysis versus the Si-F/Si-O bond ratio. Regardless of process condition, a strong correlation for a universal function of refractive index vs. bond ratio can be seen. As is generally the case for doped oxides or oxides of varying stoichiometry, the chemical content of the film dominates the refractive index. Other factors like stress and film density affect the refractive index in a second order manner. This relationship can be of value in a mass production line for rapidly monitoring the fluorine content of a film.

A representative gap fill of an aspect ratio line/space of about 1.4:1 and a Si-F/Si-O ratio of about 2.5% is shown in Figure 9. No seams or voids were visible for this process condition for aspect ratios of less than or equal to 1.4:1. The process window for gap fill was very large, i.e. many process conditions yielded gap fill results superior to undoped PECVD TEOS. Gap fill ability generally increased with increasing percentage of low frequency power and decreasing pressure, consistent with the mechanisms of simultaneous deposition and etch described in an article by T. Usami *et al.*, "Low Dielectric Constant Interlayer Using Fluorine-Doped Silicon Oxide," Japan J. Appl. Phys., Vol. 33, 1994, pp. 408-412, which is incorporated herein by reference. The gap fill was not a clear function of Si-F content in the film. Conditions of very high fluorine content did not yield optimum gap fill results, as can be seen from a comparison of Figure 9 with Figure 10. Figure 10 shows a representative gap fill of an aspect ratio line/space of about 1.4:1 and a Si-F/Si-O ratio of about 3%. Note that the fill performance is not as good as the optimized film shown in Figure 9.

While excellent gap fill ability is important, reliable integration of an F-TEOS film into a device structure requires film stability as well. Two important factors to consider in a study of the stability of F-TEOS films are the stability of the Si-F bond itself over the range of process conditions that the film may be subjected to during routine semiconductor processing, and the moisture absorption characteristics of the film.

The first factor is the stability of the Si-F bond itself over the range of process conditions that the film may be subjected to during routine semiconductor processing. One test for Si-F bond stability is to measure the "before and after" anneal Si-F/Si-O bond areas as a function of initial Si-F/Si-O bond density. Figure 11 is a plot of the Si-F/Si-O bond areas for one percent, two percent, and three percent fluorine after a 90 minute, 500° C anneal in $N_2$. Films with initial Si-F/Si-O bond densities below approximately 2.5 - 3.0 percent and initial stresses of $0.5 \times 10^9$ dynes/cm$^2$ compressive remained stable in this physical test (i.e. no change in the bond ratio), whereas films of higher initial fluorine content and of lower stress tended to exhibit a decrease in the bond ratio, signifying a loss of Si-F to the ambient. Such a release of free fluorine would not be desired during an integration sequence, as free fluorine tends to react with subsequent device layers and result in a decrease in reliability or yield.

The second factor is the moisture absorption characteristics of the film. Stability of the films with respect to moisture absorption are consistent with stability of the Si-F bond. Figure 12 is a plot of the initial Si-OH/Si-F bond ratio (the change in which tracks with moisture absorption) versus time in a 100° C boiling water bath. For films of approximately 2% Si-F to Si-O ratio and below, there is no change in Si-OH content after 100 minutes in the water. Films of higher initial Si-F/Si-O ratio exhibited initial SiOH (and water) area increase followed by an apparent decrease after 100 minutes exposure in boiling water. Post boiling thickness measurements indicated that this apparent Si-OH decrease is explained by an overall film thickness decrease due to HF formation and subsequent etching during the long boiling test.

Figure 12 can be better understood with reference to Figure 13, which is a plot of the Si-F/Si-O bond ratio versus boiling time for three different Si-F/Si-O initial conditions. In the case of the stable films (*i.e.* no measurable Si-OH changes), there is relatively little or no change in the Si-F/Si-O ratio. However, in films that exhibit large Si-OH changes, the Si-F area is found to consistently decrease over the entire boiling cycle. This Si-F decrease is the source of fluorine for HF formation and subsequent etching of the greater than 2.5-3% Si-F/Si-O as-deposited fluorine-TEOS film.

*High Low Frequency Power - High Oxygen Flow Study*

We believe that a higher percentage of low frequency power (higher ion bombardment energy flux per layer deposited) and high oxygen flows are important for obtaining films of acceptable stability with high fluorine content. This relationship was explored in another study in which we investigated the modulation of the percent of low frequency power with optimization of the $O_2:C_2F_6$ ratios. We used a reactor similar to the dual frequency multi-station sequential PECVD reactor in our low power study, but modified with a more powerful low frequency RF generator and a smaller electrode spacing. Prolonged temperature and humidity testing as well as film boiling were used as stability indicators.

We found that gap fill of a 1.4:1 aspect ratio space was achieved with no visible seams or voids present, as in our low power study. While films with Si-F to Si-O bond peak ratios in the 6% + range could be deposited, film stability (i.e., Si-F bond stability) deteriorated if this bond ratio exceeded 3.5 % by our measurement technique or if stress was less compressive than $0.8 \times 10^9$ dynes/cm$^2$. Generally, the Si-F bond stability improved with increasing $C_2F_6:O_2$ ratio, increasing low frequency power, and decreasing TEOS flow; the refractive index increased with decreasing $C_2F_6:O_2$ ratio, decreasing low frequency power, and increasing TEOS flow; the compressive stress increased with decreasing $C_2F_6:O_2$ ratio, increasing low frequency power, and decreasing TEOS flow; and the gap fill characteristics improved with increasing $C_2F_6:O_2$ ratio and increasing low frequency power. Generally, high low frequency ion bombardment energy and flux, low pressure, and a high oxygen flow were found to be desirable. The amount of low frequency power and the $C_2F_6:O_2$ ratio were found to be coupled parameters.

We believe the mechanism behind the F-TEOS process to be that the low frequency energy densifies and incorporates fluorine into the oxide lattice and reactively ion etches sharp corners to create flow shapes, and that fluorine adsorbs on the surface to improve surface diffusion of precursors. Low pressure increases the effective energy of the bombarding ions and enhances the aforementioned mechanism at a slight expense of deposition rate. High oxygen partial pressures fully reacts unstable surface species, resulting in a more stable film.

In our high low frequency power study, we modified a Concept One reactor to provide low frequency power preferably at 400 KHz and 1500-2100 Watts, and a spacing between the showerhead and the heater block, or platen, of preferably 380 mils. Preferably, the 13.56 MHz high frequency power was in the range of 250-600 Watts. Preferably, process gas flows were in the range of 1.5-3.0 ml/min for TEOS, 8.0-18.0 slm for $O_2$, and 1.0-3.0 slm for $C_2F_6$, total chamber pressure was in the range of 1.0-3.5 Torr, and the process temperature was 350-400 degrees Centigrade with 350 degrees being preferable. This illustrative configuration is referred to as the Hi LF configuration.

It will be understood that the ranges stated are illustrative, and suitable F-TEOS films can be obtained with parameter values outside of the stated ranges. For example, low frequency varying about 400 KHz and as low as 100 KHz is suitable in some applications. Spacing varying about 380 mils in a rang from as close together as possible to as far apart as possible without causing arcing, is suitable in some applications. More or less high frequency power, or no high frequency power, high frequency power, is suitable in some applications. In addition, other gas flows may be used, and other inert gases such as argon, krypton, xenon, helium, and neon may be added to the reaction mixture. Good stability is obtained at $0_2$:TEOS partial pressure ratios in excess of 20:1, with greater than 40:1 being preferable.

We compared the physical properties of F-TEOS films of varying concentrations to films deposited in a high density plasma (hereinafter "HDP") inductively coupled plasma reactor using $SiF_4+O_2+Ar$ mixtures at less than 10 mTorr pressure. The use of an HDP reactor having a high ratio of ion bombardment energy flux to deposition rate has yielded films of superior moisture and thermal stability. The HDP system and results are described in W. van den Hoek, *et al*, "A New High Density Plasma Source for Void Free Dielectric Gap Fill," Semicon Japan Technical Proceeding, November, 1994, which is incorporated herein by reference in its entirety.

The films in our high low frequency power study were deposited on 200 mm wafers. Each set process conditions was represented by at least two trials. Thickness was measured by using the aforementioned Prometrix SM200 thin film thickness reflectometer, with 225 points being measured on each 200 mm wafer. The refractive index was measured using the aforementioned Metricon Prism coupler. Stress was measured using the aforementioned FSM 8800 stress measurement gauge. The aforementioned Biorad FTIR was used for measuring the fluorine content. Si-F concentrations were calculated using the ratio of the 937 cm$^{-1}$ Si-F peak to the 1070 cm$^{-1}$ Si-O peak after baseline correction.

Our low power study indicated that the Si-F content for standard PECVD F-TEOS films could be controlled thorough modulation of the $0_2$:$C_2F_6$ ratios. This has not changed in the Hi LF PECVD case, and the HDP fluorine content is similarly controlled by process. We also demonstrated in our low power study that there was a fundamental relationship between refractive index and Si-F bond content for the standard PECVD F-TEOS case regardless of process conditions. Refractive index versus Si-F content for the standard PECVD F-TEOS films, the Hi LF F-TEOS films, and our HDP films generated for this study is shown in Figure 14. While there still appears to be a unique Si-F content to refractive index relationship for all process conditions, this relationship is shifted to higher refractive index values for a given Si-F content for the Hi LF and HDP films. Furthermore, the data in Figure 14 indicate that the relationship for the HDP case and the Hi LF F-TEOS case are nearly identical. This is in spite of entirely different process chemistries and plasma processing environments. The higher refractive index for the same film Si-F content is attributed to a net higher film density due to increased ion bombardment during film formation. Both HDP and Hi LF films seem to show an equivalent densification when compared to the standard PECVD F-TEOS film. This suggest that the mechanism for densification is similar in these two cases.

The other key physical property previously described was the relationship between Si-F content and stress for films deposited at a constant percentage of low frequency power conditions. In our low power study, we showed that film stress decreases towards more tensile values with increasing Si-F content for fixed percentages of low frequency power and high frequency power. Figure 15 shows the relationship between stress and Si-F content for all process conditions in the Hi LF mode and the HDP mode. Both the Hi LF and the HDP films still exhibit the same general trend of decreasing compressive stress as Si-F content is increased. Also, for Si-F content in the 2.5% to 5% range, the HDP and Hi LF films exhibit nearly identical results. However, the HDP film does show a change in slope of this relationship below 2% content, presumably due to the different gas chemistries used.

The stability of films with respect to moisture can be measured several ways. One method that has been used successfully is prolonged exposure to a 100% relative humidity (RH) environment at elevated temperatures. Figure 16 is a plot of SiOH atomic percent for three Si-F content Hi LF cases versus time in a 100% RH, 65 degree Centigrade oven. Figure 17 is a plot of HOH atomic percent for three Si-F content Hi LF cases versus time in a 100% RH, 65 degree Centigrade oven. The SiOH content shows a small increase during the first day of exposure for lower Si-F content films, but remains stable over the five day period. The SiOH content is stable for the entire time for the 2% and 3 % cases. The Si-F content for the 1% and 2% films did not change during this test, with a loss of 0.5% Si-F in the 3% case over the 5 day test. Note that over the 5 day period, none of the Hi LF films show any water uptake.

Immersion of the films in boiling water and subsequent measure of the changes in the film physical properties in another way of monitoring film moisture resistance. Figure 18 and Figure 19 are expansions of the portion of the FTIR spectrum where SiOH and HOH absorbencies are observed for a 2.5% Si-F content Hi LF F-TEOS film after boiling in water for 100 minutes. Note that the scale of Figure 19 is 50 times smaller than the scale for Figure 18. These results are very similar to known ECR HDP films and the films deposited in the HDP source used in this study.

The physical tests have been validated by subsequent device electrical testing and reliability burn-in. Three different device lots where burned-in for greater than 240 minutes with no adverse yield input or device degradation. The hot box test and the device electrical tests are better indicators of film stability then the thermal annealing test in our low power study.

This study corroborates the validity of using the refractive index vs. Si-F content relationship as shown in Figure 14 as a monitor of film stability. The inertness of the Hi LF films in a wet environment constitutes a marked improvement over more conventional PECVD F-TEOS films. Hence, by using an improved, Hi LF configuration PECVD F-TEOS films were deposited that are similar to HDP films in terms of moisture resistance.

Figure 20 and Figure 21 are plots of dielectric constant versus Si-F/Si-O bond ratios and refractive index versus Si-F/Si-O bond ratios for several illustrative cases. These Figures show that F-TEOS films have unique Si-F/Si-O bond content versus refractive index and dielectric constant relationships. The fluorine content an the resulting dielectric constant is thus easily monitored in the production line.

In an illustrative marathon deposition run, the modified Concept One reactor was run at 2300 Watts total power and 75 percent low frequency power, with a process chamber pressure of 2.6 Torr, a process temperature of 350 degrees Centigrade, and process gas flows of 2.75 ml/min TEOS, 12 slm $O_2$, and 2 slm $C_2F_6$. Averaged over 1200 wafers in the marathon run, the deposition rate was 2748 Å/min, the WiW 1 sigma percent was 1.1%, the WtW 1 sigma percent was 0.96%, the stress was -0.81 ± 0.02 x $10^9$ dynes/cm$^2$, the refractive index was 1.4199 ± 0.0007, particles at 0.2 μm were 17 adders, and the Si-F/Si-O bond ratio was 3.3%.

While our invention has been described with respect to the embodiments and variations set forth above, these embodiments and variations are illustrative and we do not necessarily consider our invention to be limited in scope to these embodiments and variations. For example, electrode spacing, power levels, gas flows, total pressure, partial pressures, and temperature can be varied to achieve different deposition rates and film characteristics. Accordingly, other embodiments and variations not described herein may be considered within the scope of our invention as defined by one or more of the following claims.

**Claims**

1. A method of depositing a plasma enhanced chemical vapor deposition fluorine-doped silicon dioxide film, comprising:

   maintaining a substrate in a plasma-enhanced chemical vapor deposition reactor;
   introducing a gas mixture comprising a TEOS component, an oxygen component, and a fluorine component into the reactor, wherein the ratio of oxygen partial pressure to TEOS partial pressure is substantially high; and
   applying alternating current energy to the gas mixture to excite the gas mixture into a plasma proximate to the substrate.

2. A method as in claim 1 wherein the TEOS component is gasified TEOS, the oxygen component is $O_2$, and the fluorine component is $C_2F_6$.

3. A method as in claim 1 wherein dual RF frequency energy is used, the amount of low frequency energy being substantially greater than the amount of high frequency energy.

4. A method as in claim 1 wherein the ratio of oxygen partial pressure to TEOS partial pressure is greater than about 20:1.

5. A method of process integration comprising depositing a stable, low dielectric constant film using the steps of claim 1 and excluding depositing an encapsulation layer associated with the stable, low dielectric constant film.

110

2:1

120

1:1

130

1:2

PRIOR ART
**FIG. 1**

202

200

PRIOR ART
**FIG. 2**

304

302

306

300

308

PRIOR ART
**FIG. 3**

FIG. 4

Actual DR

```
              1736.00        2326.00
         ┌─────────────┬─────────────┐
        /             /│            /│
       /             / │           / │
   B+ /─────────────/──┼──────────/  │
     │ 2314.00  │  3221.00        │  │
     │          │                 │  │
  0  │          │  2311.00     2061.00│ C+
  2  │          │ ─────────────│─────│
     │          /              │    / 6
     │         /               │   / C 2F
     │        /                │  /
  B- │ 2163.00    3040.00      │ / C-
     └─────────────────────────┘/
     A-          TEOS          A+
```

Actual %F

```
              0.27           1.00
         ┌─────────────┬─────────────┐
        /             /│            /│
       /             / │           / │
   B+ /─────────────/──┼──────────/  │
     │ 1.39     │  1.36           │  │
     │          │                 │  │
  0  │          │  1.64        2.93 │ C+
  2  │          │ ─────────────│─────│
     │          /              │    / 6
     │         /               │   / C 2F
     │        /                │  /
  B- │ 1.24       0.88         │ / C-
     └─────────────────────────┘/
     A-          TEOS          A+
```

Actual Uniformity

```
              4.46           1.18
         ┌─────────────┬─────────────┐
        /             /│            /│
       /             / │           / │
   B+ /─────────────/──┼──────────/  │
     │ 1.19     │  2.36           │  │
     │          │                 │  │
  0  │          │  1.23         1.68│ C+
  2  │          │ ─────────────│─────│
     │          /              │    /
     │         /               │   / C 2F6
     │        /                │  /
  B- │ 1.62       1.15         │ / C-
     └─────────────────────────┘/
     A-          TEOS          A+
```

Actual Rd

```
              1.39           1.42
         ┌─────────────┬─────────────┐
        /             /│            /│
       /             / │           / │
   B+ /─────────────/──┼──────────/  │
     │ 1.42     │  1.44           │  │
     │          │                 │  │
  0  │          │  1.42         1.42│ C+
  2  │          │ ─────────────│─────│
     │          /              │    /
     │         /               │   / C 2F6
     │        /                │  /
  B- │ 1.44       1.44         │ / C-
     └─────────────────────────┘/
     A-          TEOS          A+
```

FIG. 5

FIG. 6

FIG. 7

FIG. 8

#9 center w/o etch

000056 25KV X35.0K 0.86 μm

FIG. 9

#11 center w/o etch

000059 25KV X35.0K 0.86 μm

FIG. 10

EP 0 759 481 A1

FIG. 11

FIG. 12

**FIG. 13**

FIG. 14

FIG. 15

FIG. 17

FIG. 16

**FIG. 18**

**FIG. 19**

**FIG. 20**

**FIG. 21**

European Patent
Office

**EUROPEAN SEARCH REPORT**

Application Number

EP 96 20 1647

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X,D | JAPANESE JOURNAL OF APPLIED PHYSICS, vol. 33, no. 1B, 1 January 1994, pages 408-412, XP000577615 USAMI T ET AL: "LOW DIELECTRIC CONSTANT INTERLAYER USING FLUORINE-DOPED SILICONE OXIDE" | 1,2,4,5 | C23C16/40 C23C16/50 H01L21/316 |
| Y | * page 408, Experimental section * | 3 | |
| | --- | | |
| X | EP-A-0 367 004 (TEXAS INSTRUMENTS INC) 9 May 1990 * page 4; example 1 * | 1,5 | |
| | --- | | |
| Y | PROC. - ELECTROCHEM. SOC. (1995), 95-5(ULSI SCIENCE AND TECHNOLOGY, 1995), 318-26 CODEN: PESODO;ISSN: 0161-6374, 1 January 1995, XP000603537 MIZUNO, SHINSUKE ET AL: "Improved gap-filling capability of fluorine -doped PECVD silicon oxide thin film" * page 320, paragraph 1 * | 3 | |
| | --- | | TECHNICAL FIELDS SEARCHED (Int.Cl.6) |
| P,X | JAPANESE JOURNAL OF APPLIED PHYSICS, PART 2 (LETTERS), 1 MARCH 1996, PUBLICATION OFFICE, JAPANESE JOURNAL APPL. PHYS, JAPAN, vol. 35, no. 3A, ISSN 0021-4922, pages L273-L275, XP000603554 WOO SIK YOO ET AL: "Intermetal dielectric gap fill by plasma enhanced chemical vapor deposited fluorine-doped silicon dioxide films" * the whole document * | 1-5 | C23C |
| | --- | | |
| | -/-- | | |

The present search report has been drawn up for all claims

| Place of search | Date of completion of the search | Examiner |
|---|---|---|
| THE HAGUE | 3 October 1996 | Patterson, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 96 20 1647

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| P,X | JPN. J. APPL. PHYS., PART 1 (1996), 35(2B), 1583-7 CODEN: JAPNDE;ISSN: 0021-4922, 1996, XP000603549 KUDO, HIROSHI ET AL: "Densified SiOF film formation for preventing water absorption" * page 1583, left-hand column, line 24 - line 26; table I * --- | 1-5 | |
| A | GB-A-2 256 967 (MOTOROLA INC) 23 December 1992 * page 5, line 4 - line 14 * ----- | 3 | |
| | | | TECHNICAL FIELDS SEARCHED (Int.Cl.6) |

The present search report has been drawn up for all claims

| Place of search | Date of completion of the search | Examiner |
|---|---|---|
| THE HAGUE | 3 October 1996 | Patterson, A |

EPO FORM 1503 03.82 (P04C01)